# EUROPÄISCHE PATENTSCHRIFT

(11) **EP 2 603 067 B1**
(45) Veröffentlichungstag und Bekanntmachung des Hinweises auf die Patenterteilung: **23.09.2015**
(21) Anmeldenummer: 11405365.5
(22) Anmeldetag: 09.12.2011
(51) Int. Cl.: H05K 7/14

(54) **Verriegelungsvorrichtung**
Locking device
Dispositif de verrouillage

(43) Veröffentlichungstag der Anmeldung: 12.06.2013
(73) Patentinhaber: DET International Holding Limited, George Town, Grand Cayman (KY)
(72) Erfinder: Bollenbach, Markus, 3014 Bern (CH)
(74) Vertreter: Stäbler, Roman

(56) Entgegenhaltungen:
- DE-A1- 3 146 904
- DE-U1- 29 717 491
- FR-A- 1 461 852
- US-A1- 2011 182 006
- US-B1- 6 181 549

## Beschreibung

### Technisches Gebiet

Die Erfindung betrifft eine Verriegelungsvorrichtung zum Verriegeln eines Einschubgeräts in einer Halterung. Einschubgeräte, die in eine Halterung, ein Rack oder ein Shelf eingeschoben werden, stellen bei Erreichen einer Endposition in der Halterung eine elektromechanische Verbindung mit der Halterung z. B. einem Backplane her. Die Verriegelungsvorrichtung des Einschubgeräts dient dazu, das Einschubgerät in der Endposition zu sichern, so dass Vibrationen oder Erschütterungen das Gerät nicht aus der definierten Endposition lösen können. Eine solche Verriegelungsvorrichtung kann nur manuell von einem Benutzer gelöst und das Einschubgerät aus der Halterung herausgezogen werden.

### Stand der Technik

Aus dem Stand der Technik sind bereits Verriegelungsvorrichtungen zum Verriegeln von Einschubgeräten in Halterungen bzw. Racks bekannt.

Beispielsweise offenbart die DE 198 27 074 A1 (FESTO AG & Co) eine Haltevorrichtung, die zur Befestigung einer Einschubkarte in einem Einschubgehäuse dient. Sie umfasst wenigstens ein Halteelement, das über Rastmittel verfügt, die bei eingesteckter Einschubkarte mit Rastgegenmitteln des jeweils anderen Bauteils in Rasteingriff gelangen.

Das Halteelement verfügt über ein federelastisches Element, das die Rastmittel in ihre Haltestellung vorspannt. Das Rastmittel rastet bei einem Einschieben der Einschubkarte in das Einschubgehäuse selbständig in einer Einschubposition ein.

Die DE 3146904 A1 (Standard Elektrik Lorenz AG) beschreibt eine Verriegelungsvorrichtung für in Baugruppenträger einschiebbare Baugruppen der Nachrichtentechnik. Sie umfasst einen federnden Steg, welcher geeignet Ist, die Verriegelungsvorrichtung bei einem Einschieben der Baugruppe in den Baugruppenträger in eine Quernut des Baugruppenträgers einrasten zu lassen.

Die DE 6,181,549 B1 (Mills et al.) offenbart ein Verrlegelungssystem für eine elektronische Komponente in einem Rack mit einem ersten Verriegelungselement, welches ein erstes Rastelement umfasst und Bestandteil der elektronischen Komponente ist. Das Verriegelungssystem umfasst weiter ein zweites Verriegelungselement mit einem zweiten Rastelement, welches Bestandteil des Racks ist. Mindestens eines der Verriegelungselemente ist schwenkbar gelagert und kann mit einer Kraft beaufschlagt werden, um beide Rastelemente gegeneinander zu drücken. Das Verriegelungssystem umfasst ferner einen Anschlag zur Begrenzung eines maximalen Schwenkweges des schwenkbaren Verriegelungselements in der Wirkrichtung der Kraft.

FR 1 461 852 A (Philips) beschreibt ein elektrisches Gerät, welches zwischen zwei Führungsschienen in ein Gehäuse eingeführt und mit einer Haltevorrichtung darin fixiert werden kann. Die Haltevorrichtung ist auf der Frontseite des Gehäuses in einer Ausnehmung angebracht und umfasst zwei Riegel. Der erste Riegel greift in eine Ausnehmung des Gehäuses ein und fixiert so das elektrische Gerät verschiebsicher im Gehäuse. Der zweite Riegel ragt aus dem Gehäuse hinaus und bildet einen Griff, mit dem die Haltevorrichtung entgegen einer Federkraft horizontal bewegt werden kann.

Die bekannten Verriegelungsvorrichtungen weisen jedoch unterschiedliche Nachteile auf. So ist beispielsweise das Einschieben oder das Herausziehen eines Einschubgeräts in die bzw. aus der Halterung nicht in allen Fällen einfach möglich. Auch wird von vielen bekannten Verriegelungsvorrichtungen nicht sichergestellt, dass auch nicht vollständig korrekt eingeschobene Geräte in den Halterungen zuverlässig verriegelt werden.

### Offenbarung der Erfindung

Aufgabe der Erfindung ist es, die Nachteile des Stands der Technik zu beheben bzw. zu vermindern. Insbesondere ist es Aufgabe der Erfindung, eine Verriegelungsvorrichtung zu schaffen, welche möglichst einfach zu bedienen ist, und welche eine zuverlässige und sichere Verriegelung von Einschubgeräten in Halterungen ermöglicht, speziell auch bei niedrigen bzw. schwierigen Verhältnissen.

Die Aufgabe wird mit dem Gegenstand des Anspruchs 1 dadurch gelöst, dass die Verriegelungsvorrichtung einen ersten Anschlag zur Begrenzung einer maximalen Auslenkung eines Verriegelungselements und einen zweiten Anschlag zur Begrenzung einer Überlappung zweier Rastelemente umfasst.

Die Erfindung hat gegenüber dem Stand der Technik den Vorteil, dass mechanische Toleranzen automatisch ausgeglichen werden, wodurch das Einschubgerät sicher verriegelt bleibt. Zudem werden Verformungen durch äussere Einwirkungen automatisch ausgeglichen, wodurch das Einschubgerät ebenfalls sicher verriegelt bleibt. Auch Bewegungen des

Einschubgeräts werden mithilfe der Erfindung ausgeglichen, was dazu führt, dass das Einschubgerät auch bei solchen Bewegungen sicher verriegelt bleibt.

Bei einer erfindungsgemässen Verriegelungsvorrichtung zum Verriegeln eines Geräts in einer Halterung, mit einem ersten Verriegelungselement, das ein Rastelement aufweist und von dem Gerät umfasst ist, und einem zweiten Verriegelungselement, das ein zweites Rastelement aufweist und von der Halterung umfasst ist, ist wenigstens eines der Verriegelungselemente beweglich gelagert und zur Verriegelung der beiden Rastelemente mit einer Kraft beaufschlagbar. Dabei umfasst die Verriegelungsvorrichtung einen ersten Anschlag zur Begrenzung einer maximalen Auslenkung des beweglichen Verriegelungselements bzw. zur Definition einer Maximal-Auslenkungsposition des beweglichen Verriegelungselements. Eine solche erfindungsgemässe Verriegelungsvorrichtung umfasst einen zweiten Anschlag zur Begrenzung einer Überlappung der beiden Rastelemente im verriegelten Zustand bzw. zur Definition einer Maximal-Überlappung der beiden Rastelemente im verriegelten Zustand. Bei typischen Ausführungsformen ist das zweite Verriegelungselement das zweite Rastelement.
Bei typischen Ausführungsformen sind die beiden Anschläge derart angeordnet, dass das bewegliche Verriegelungselement beim Verriegeln der beiden Verriegelungselemente an dem zweiten Anschlag anschlägt, bevor es an dem ersten Anschlag anschlägt. Dies ist sowohl dann der Fall, wenn sich das Gerät in einer Normallage in der Halterung befindet, als auch dann, wenn das Gerät nicht korrekt in die Halterung eingeführt ist. Im letzteren Fall führt die Tatsache, dass zwischen dem beweglichen Verriegelungselement und dem ersten Anschlag noch ein gewisser Abstand vorhanden ist, wenn das Verriegelungselement an dem zweiten Anschlag anschlägt, dazu, dass ein durch das nicht korrekt eingeführte Gerät auftretender Abstand zwischen einem Gerätegehäuse und der Halterung ausgeglichen werden kann.

Bei vorteilhaften Ausführungsformen umfasst die Verriegelungsvorrichtung ein Federelement zur Beaufschlagung des beweglichen Rastelements und/oder des beweglichen Verriegelungselements mit der Kraft. Alternativ dazu ist es auch möglich, dass das erste Element selbst so schwer ist, dass es durch die Schwerkraft mit der Kraft beaufschlagbar wird.

Bei vorteilhaften Ausführungsformen ist das Federelement einerseits an dem beweglichen Verriegelungselement und andererseits an dem Gerät bzw. der Halterung abgestützt.

Bei einer vorteilhaften Verriegelungsvorrichtung ist das erste Verriegelungselement drehbar an einem Gehäuse des Gerätes gelagert. Es ist jedoch prinzipiell auch möglich, dass das erste Verriegelungselement drehbar an dem Gerät selbst oder an der Halterung gelagert ist. Das zweite Federelement umfasst typischerweise eine Feder, welche an dem ersten Verriegelungselement befestigt und an dem Gehäuse des Gerätes abgestützt ist. Alternativ ist es auch möglich, dass das Federelement an dem zweiten Verriegelungselement befestigt und/oder an dem Gerät selbst oder der Halterung abgestützt ist.

Bei einer typischen Verriegelungsvorrichtung umfasst das erste Rastelement eine Rastnase zum Eingreifen in eine Ausnehmung und/oder eine Rastöffnung der Halterung. Alternativ dazu oder zusätzlich kann auch das zweite Rastelement bzw. das zweite Verriegelungselement eine Rastnase zum Eingreifen in eine Ausnehmung und/oder eine Rastöffnung des Gehäuses des Geräts bzw. des Geräts selbst umfassen.

Bei vorteilhaften Ausführungsformen umfasst das erste Rastelement und/oder das zweite Rastelement eine Anschlagskante zum Anschlagen an dem zweiten Anschlag.

Besonders vorteilhaft ist es, wenn das erste Rastelement und/oder das zweite Rastelement eine erste Einfahrschräge zum Erleichtern eines Einfahrens des Geräts in die Halterung umfasst. Bei vorteilhaften Ausführungsformen ist die erste Einfahrschräge zwischen der Rastnase und der Anschlagskante angeordnet.

Bei besonders vorteilhaften Ausführungsformen umfasst das erste Rastelement und/oder das zweite Rastelement eine zweite Einfahrschräge zum Erleichtern eines Einfahrens des Geräts in die Halterung. Bei typischen Ausführungsformen ist die zweite Einfahrschräge von der Rastnase aus gesehen hinter der ersten Einfahrschräge und/oder der Anschlagskante angeordnet.

Bei einer vorteilhaften Verriegelungsvorrichtung ist der erste Anschlag durch die Halterung gebildet und/oder der zweite Anschlag ist durch die Halterung gebildet. Zusätzlich oder alternativ dazu können die Anschläge auch vom Gehäuse des Geräts oder vom ersten Verriegelungselement gebildet sein.

Bei vorteilhaften Ausführungsformen ist das zweite Verriegelungselement durch die Ausnehmung der Halterung gebildet. Dies hat den Vorteil, dass die Halterung selbst keine beweglichen Teile umfassen muss, wodurch sich ihre Handhabung und Wartung vereinfacht.

Ein erfindungsgemässes Gerät zur Montage einer Halterung umfasst vorteilhafterweise zumindest ein erstes erfindungsgemässes Verriegelungselement.

Eine erfindungsgemässe Halterung zur Aufnahme eines Geräts umfasst typischerweise zumindest ein zweites erfindungsgemässes Verriegelungselement.

### Figurenbeschreibung

Im Folgenden wird die Erfindung anhand von Figuren näher erläutert. Dabei zeigen:
- Figur 1:: eine perspektivische Ansicht eines Geräts, welches mithilfe einer erfindungsgemässen Verriegelungsvorrichtung in einer Halterung verriegelt wird;
- Figur 2:: eine Seitenansicht eines Geräts, welches mithilfe einer erfindungsgemässen Verriegelungsvorrichtung in einer Halterung verriegelt wird;
- Figur 3:: eine Seitenansicht eines Rastelements einer erfindungsgemässen Verriegelungsvorrichtung (stark vergrössert);
- Figur 4:: eine perspektivische Ansicht einer erfindungsgemässen Verriegelungsvorrichtung, welche an der Innenseite eines Gerätegehäuses montiert ist;
- Figur 5:: eine Seitenansicht einer erfindungsgemässen Verriegelungsvorrichtung zu Beginn eines Einfahrvorgangs;
- Figur 6:: eine Seitenansicht einer erfindungsgemässen Verriegelungsvorrichtung während eines Einfahrvorgangs;
- Figur 7:: eine Seitenansicht einer erfindungsgemässen Verriegelungsvorrichtung am Ende eines Einfahrvorgangs;
- Figur 8:: eine Seitenansicht einer erfindungsgemässen Verriegelungsvorrichtung zu Beginn eines Ausziehvorgangs;
- Figur 9:: eine Seitenansicht einer erfindungsgemässen Verriegelungsvorrichtung während eines Ausziehvorgangs;
- Figur 10:: eine Seitenansicht einer erfindungsgemässen Verriegelungsvorrichtung bei nicht korrekt eingeführtem Gerät in eine Halterung;
- Figur 11:: eine perspektivische Ansicht einer erfindungsgemässen Verriegelungsvorrichtung, welche an der Innenseite eines Gerätegehäuses montiert ist, in ihrer Ausgangslage;
- Figur 12:: eine perspektivische Ansicht einer erfindungsgemässen Verriegelungsvorrichtung, welche an der Innenseite eines Gerätegehäuses montiert ist, in ihrer Verriegelungslage;
- Figur 13:: eine perspektivische Ansicht einer erfindungsgemässen Verriegelungsvorrichtung, welche an der Innenseite eines Gerätegehäuses montiert ist, in ihrer Maximallage;
- Figur 14:: eine perspektivische Ansicht eines weiteren Ausführungsbeispiels einer erfindungsgemässen Verriegelungsvorrichtung mit zwei ersten und zwei zweiten Verriegelungselementen und
- Figur 15:: eine ausschnittsweise vergrösserte Darstellung der Verriegelungsvorrichtung aus Figur 14.

### Beschreibung eines bevorzugten Ausführungsbeispiels

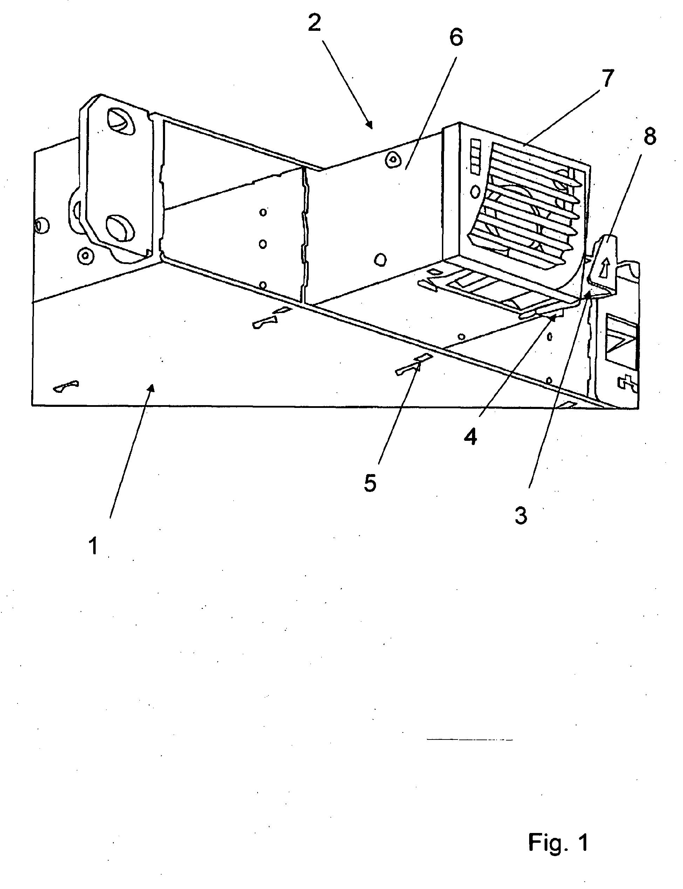

Figur 1 zeigt ein Gerät 2, welches mithilfe einer erfindungsgemässen Verriegelungsvorrichtung in einer Halterung 1 verriegelbar ist. Das Gerät 2 umfasst ein Gerätegehäuse 6, ein Frontelement 7 und ein Verriegelungselement 3. Das Verriegelungselement 3 umfasst ein Rastelement 4 sowie eine Bedienlasche 8 zum Bewegen bzw. Bedienen der Verriegelungsvorrichtung. Das Rastelement 4 ist derart geformt, dass es in eine Rastöffnung 5 eingreifen kann. Durch dieses Eingreifen des Rastelements 4 in die Rastöffnung 5 wird das Gerät 2 in der Halterung 1 verriegelt. Das Rastelement 4 ist derart geformt, dass es in keinem Fall über die Rastöffnung 5 hinausragen kann. Dadurch wird erreicht, dass das in der Halterung 1 verriegelte Gerät 2 in keinem Fall einen Einschub eines weiteren Geräts in die Halterung 1 verhindert, indem das Rastelement 4 aus der Rastöffnung 5 herausragt.

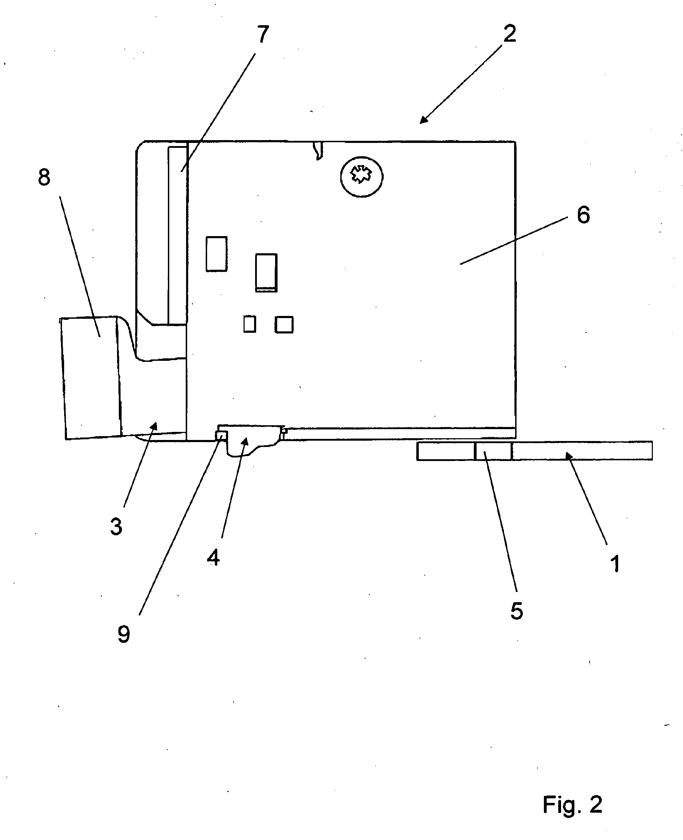

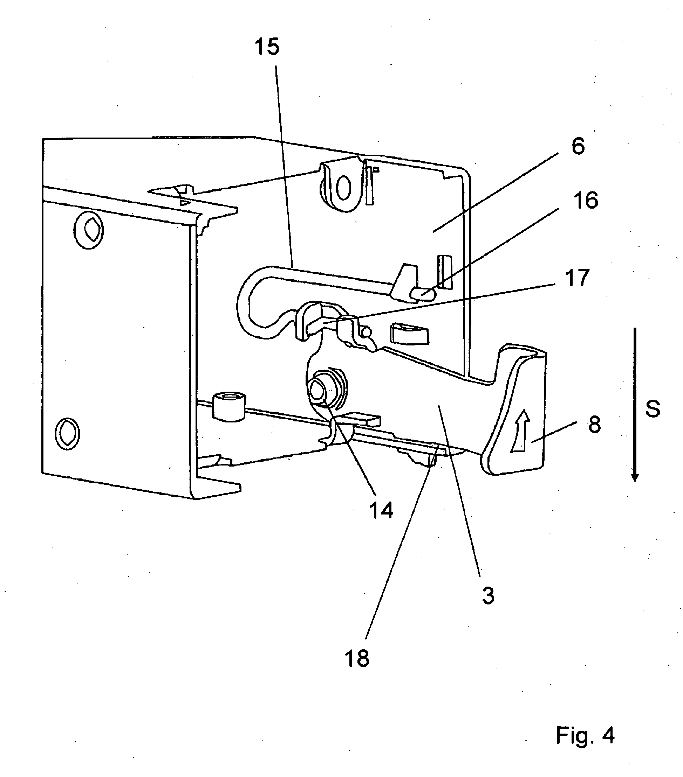

Figur 2 zeigt eine Seitenansicht einer erfindungsgemässen Verriegelungsvorrichtung zum Verriegeln eines Geräts 2, welches ein Frontelement 7, ein Gerätegehäuse 6 und ein Verriegelungselement 3 umfasst, in einer Halterung 1. Zum Verriegeln des Geräts 2 in der Halterung 1 muss das Rastelement 4 mit der Rastöffnung 5 in Eingriff kommen. In Figur 2 ist die Verriegelungsvorrichtung bzw. das Verriegelungselement 3 in ihrer bzw. seiner Ausgangsstellung gezeigt. Dabei wird das Verriegelungselement 3 von einem in Figur 2 nicht erkennbaren Federelement 15 (siehe Figur 4) mit einer Kraft beaufschlagbar, so dass das Verriegelungselement 3 auf einen ersten Anschlag 9 gedrückt wird. Der erste Anschlag 9 ist im gezeigten Ausführungsbeispiel Teil des Gerätegehäuses 6.

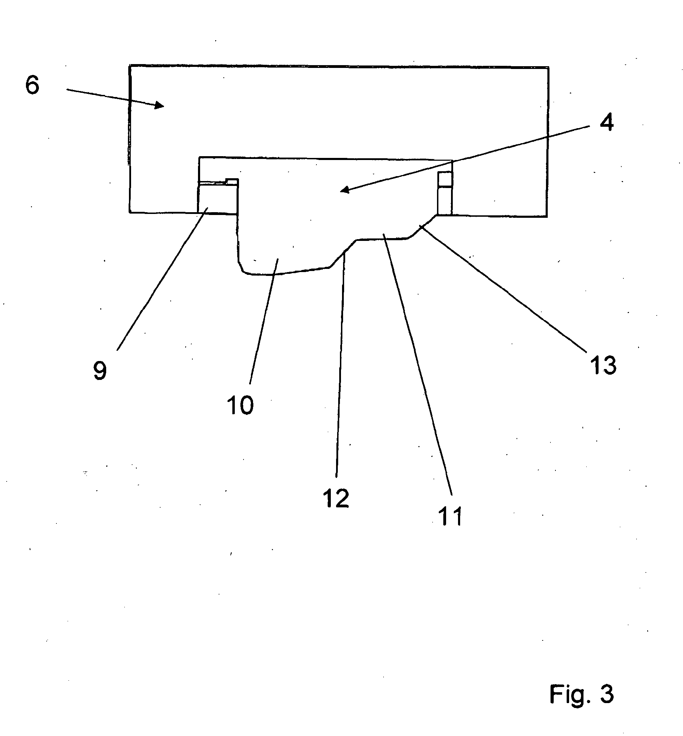

Figur 3 zeigt eine Seitenansicht eines Rastelements 4 einer erfindungsgemässen Verriegelungsvorrichtung (stark vergrössert). In Figur 3 ist erkennbar, dass das Rastelement 4 eine Rastnase 10, eine Anschlagskante 11 sowie eine erste Einfahrschräge 12 und eine zweite Einfahrschräge 13 umfasst. Die erste Einfahrschräge 12 ist hierbei zwischen der Rastnase 10 und der Anschlagskante 11 angeordnet. Die zweite Einfahrschräge 13 ist am der Rastnase 10 entgegengesetzten Ende des Rastelements 4 angeordnet. Das Rastelement 4 ragt dabei zumindest teilweise durch einen Durchgriff 9 des Gerätegehäuses 6.
In Figur 4 ist gezeigt, wie das Verriegelungselement 3 mithilfe eines Federelements 15 und einer Drehbefestigung 14 an einer Innenseite des Gerätegehäuses 6 befestigt ist. Die Drehbefestigung 14 verbindet hierbei das Verriegelungselement 3 mit dem Gerätegehäuse 6 und das Federelement 15 verspannt dabei das Federelement 3 gegen das Gerätegehäuse 6. An einer Gehäusebefestigung 16 greift das Federelement 15 unter eine Lasche. An einer Verriegelungselement-Befestigung 17 ist das Federelement 15 an dem Verriegelungselement 3 befestigt. In der in Figur 4 gezeigten Ausgangslage der Verriegelungsvorrichtung drückt das Federelement 15 das Verriegelungselement 3 auf den ersten Anschlag 18 des Gerätegehäuses 6. Wollte man das Verriegelungselement 3 von dem ersten Anschlag 18 weg bewegen, so müsste man die Bedienlasche 8 entgegen der Spannrichtung S betätigen. Dabei würde das Federelement 15 gestaucht werden.

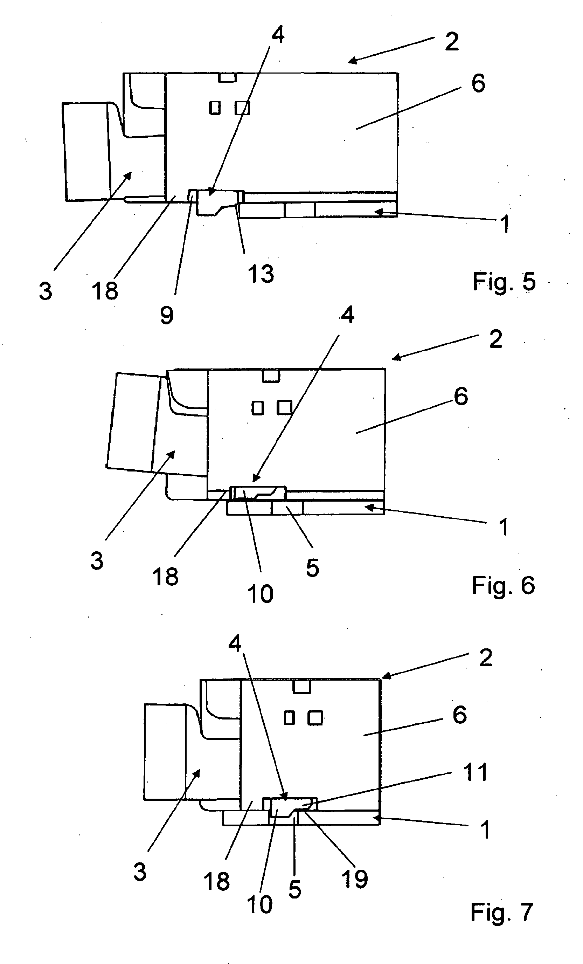

Figuren 5-7 verdeutlichen einen Einfahrvorgang des Geräts 2 mit erfindungsgemässer Verriegelungsvorrichtung in die Halterung 1. In Figur 5 sind das Gerät 2 und die Halterung 1 zu Beginn des Einfahrvorgangs gezeigt. Es ist erkennbar, dass das Verriegelungselement 3 an dem ersten Anschlag 18 des Gerätegehäuses anschlägt. Das Rastelement 4 des Verriegelungselements 3 ragt durch den Durchgriff 9 des Gerätegehäuses 6 hindurch. Die zweite Einfahrschräge 13 schlägt in der in Figur 5 gezeigten Position des Geräts 2 an einer vorderen Kante der Halterung 1 an. Würde man das Gerät 2 aus der in Figur 5 gezeigten Position nun weiter in die Halterung 1 einschieben, so würde das Rastelement 4 an seiner zweiten Einfahrschräge 13 sukzessive an der vorderen Kante der Halterung 1 herauf laufen, bis die Anschlagskante 11 (in Figur fünf der Übersicht halber nicht eingezeichnet) auf der Innenseite der Halterung 1 auffliegt. In Figur sechs sind das Gerät 2 und die Halterung 1 während des Einfahrvorgangs gezeigt. Das Verriegelungselement 3 in Figur 6 liegt nicht mehr auf dem ersten Anschlag 18 des Gerätegehäuses 6 auf, sondern ist durch die Tatsache, dass das Rastelement 4 mit seiner Rastnase 10 auf der Oberseite der Halterung 1 auffliegt, nach oben, d.h. von dem ersten Anschlag 18 des Gerätegehäuses 6 weg, ausgerichtet. Würde man das Gerät 2 nun noch weiter in die Halterung 1 einschieben, so würde das Rastelement 4 schliesslich mit der Rastöffnung 5 der Halterung 1 in Eingriff kommen. Diese so genannte Verriegelungslage der Verriegelungsvorrichtung ist in Figur 7 dargestellt. In Figur 7 ist erkennbar, dass die Rastnase 10 des Verriegelungselements 4 in die Rastöffnung 5 der Halterung 1 eingreift, wobei die Anschlagskante 11 des Verriegelungselements 4 auf einem zweiten Anschlag 19 der Verriegelungsvorrichtung, insbesondere der Halterung 1, aufliegt. In Figur 7 ist zudem erkennbar, dass das Verriegelungselement 3 nicht auf dem ersten Anschlag 18 des Gerätegehäuses 6 auffliegt, sondern dass das Verriegelungselement drei und der erste Anschlag 18 beabstandet sind. Wenn es nötig wäre, könnte das in Figur 7 nicht erkennbare Federelement 15 (siehe zum Beispiel Figur 4) das Verriegelungselement 3 also in der Verriegelungslage bis auf den ersten Anschlag 18 herunter drücken und dadurch das Rastelement 4 noch weiter durch den Durchgriff 9 (der Übersicht halber in Figur sieben nicht eingezeichnet) hindurch drücken.

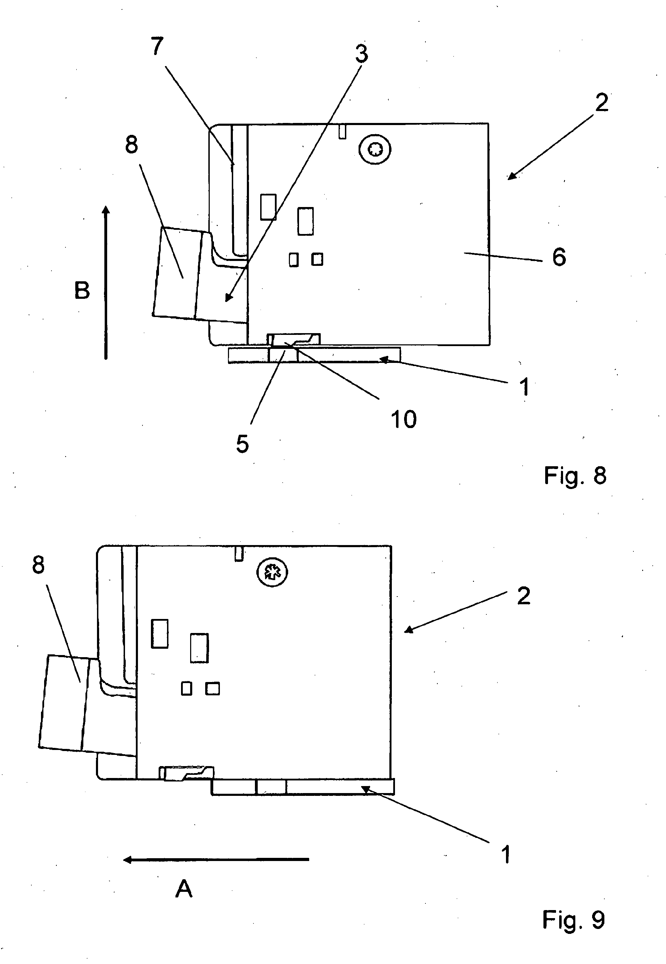

Figuren 8 und 9 visualisieren einen Ausziehvorgang für das Herausziehen des Geräts 2 aus der Halterung 1. Figur 8 zeigt hierbei den Beginn des Ausziehvorgangs, bei dem die Bedienlasche 8 in Richtung der Betätigungsrichtung B bewegt und somit das Verriegelungselement 3 bezüglich Figur 8 nach oben ausgelenkt wird. Dadurch wird die Rastnase 10 aus der Rastöffnung 5 der Halterung 1 herausgehoben. Durch Ziehen an der weiter nach oben ausgelenkten Bedienlasche 8 in Richtung der Ausziehrichtung A kann das Gerät 2 mit Gerätegehäuse 6, Frontelement 7 und Verriegelungselement 3 aus der Halterung 1 herausgezogen werden. Dieses weitere Herausziehen ist in Figur 9 dargestellt.

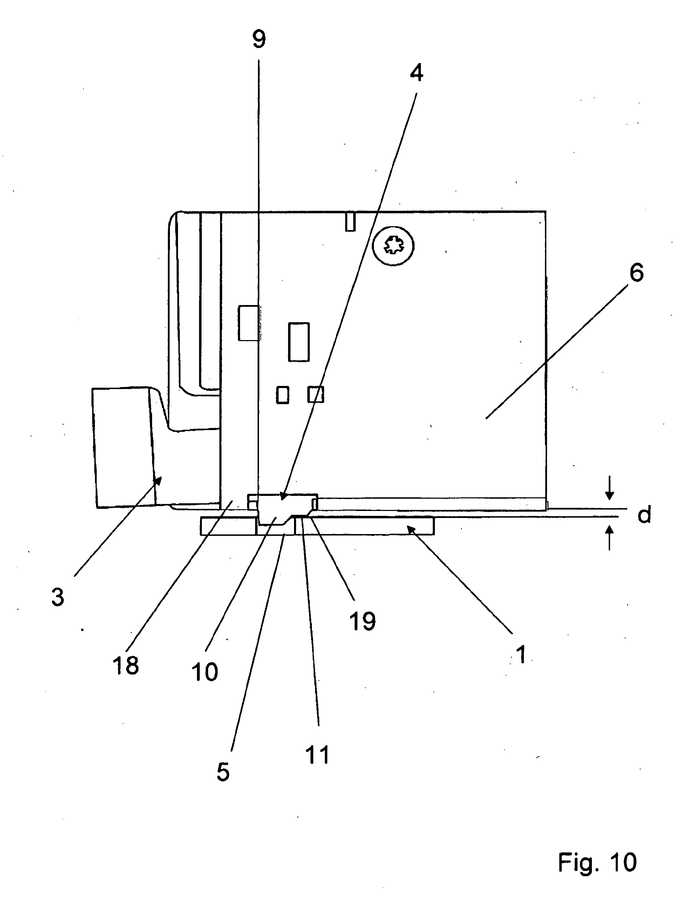

In Figur 10 ist ein Fall dargestellt, bei dem das Gerätegehäuse 6 nicht korrekt in die Halterung 1 eingeschoben ist. Die nicht korrekte Lage des Gerätegehäuses 6 bezüglich der Halterung 1 manifestiert sich unter anderem in einem Abstand d zwischen einer Innenseite der Halterung 1 und einer unteren Aussenseite des Gerätegehäuses 6. In diesem in Figur 10 gezeigten Fall ist das Verriegelungselement 3 nun weiter als in der in Figur 7 gezeigten Verriegelungslage in Richtung des ersten Anschlags 18 des Gerätegehäuses sechs gedrückt. Dadurch wird das Rastelement 4 auch weiter durch den Durchgriff 9 des Gerätegehäuses 6 hindurch gedrückt, als dies in Figur 7 der Fall ist. So wird sichergestellt, dass auch bei der in Figur 10 gezeigten nicht korrekten Lage des Gerätegehäuses 6 bezüglich der Halterung 1 die Rastnase 10 so weit in die Rastöffnung 5 eingreift, dass das Gerät 2 sicher in der Halterung 1 verriegelt wird. Gleichzeitig verhindert das Zusammenspiel zwischen der Anschlagskante 11 des Rastelements 4 und dem zweiten Anschlag 19 der Verriegelungsvorrichtung bzw. der Halterung 1, dass die Rastnase 10 über die Rastöffnung 5 und somit eine Unterseite der Halterung 1 heraus steht, wodurch das Einschieben eines weiteren Geräts in einem Fach der Halterung 1 unterhalb des in Figur 10 gezeigten Geräts 2 umkompromittiert würde.

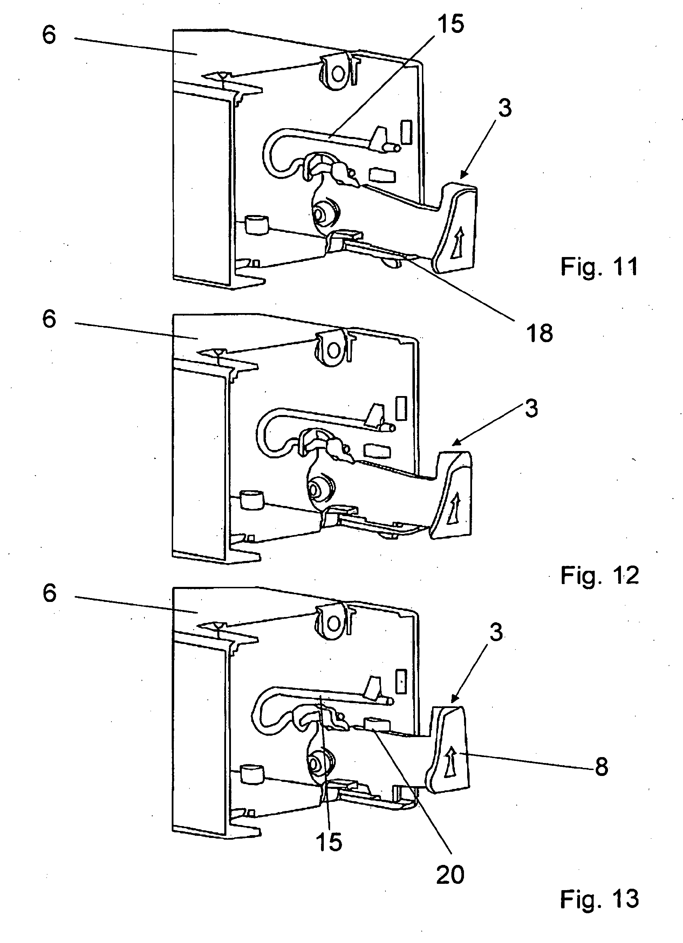

Figuren 11-13 zeigen nun perspektivische Ansichten einer erfindungsgemässen Verriegelungseinrichtung, welche an der Innenseite des Gerätegehäuses 6 montiert ist, in der Ausgangslage (Figur 11), der Verriegelungslage (Figur 12) und der Maximallage (Figur 13). In der in Figur 11 gezeigten Ausgangslage ist das Federelement 15 maximal entspannt und das Verriegelungselement 3 schlägt an dem ersten Anschlag 18 des Gerätegehäuses 6 an. In der in Figur 12 gezeigten Verriegelungslage befindet sich das Verriegelungselement 3 in einer Mittelstellung. In der in Figur 13 gezeigten Maximallage ist das Verriegelungselement 3 mithilfe der Bedienlasche 8 maximal nach oben ausgelenkt, so dass das Verriegelungselement 3 an einem Begrenzungsanschlag 20 des Gerätegehäuses 6 anschlägt. Das Federelement 15 ist dabei maximal gestaucht.

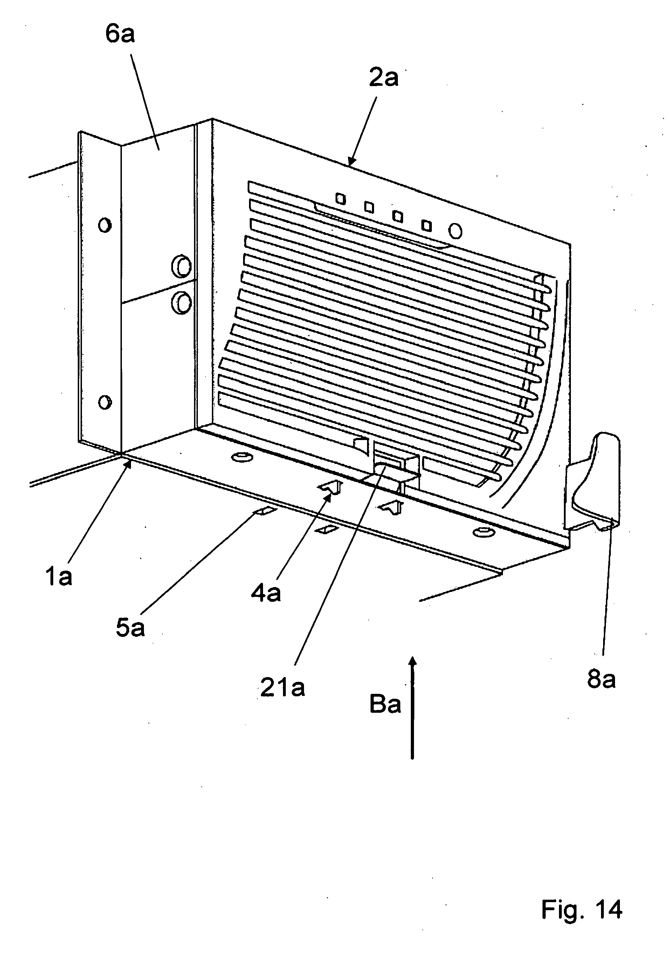

Figur 14 zeigt eine perspektivische Ansicht eines weiteren Ausführungsbeispiels einer erfindungsgemässen Verriegelungsvorrichtung mit zwei ersten und zwei zweiten Verriegelungselementen. Auch in dem in Figur 14 gezeigten Ausführungsbeispiel ist ein Gerät 2a gezeigt, welches in eine Halterung 1a eingeschoben wird. Im Unterschied zu dem in den Figuren 1 bis 13 dargestellten Ausführungsbeispiel umfasst das Gerät 2a zwei im Wesentlichen mittig am Gerät 2a angeordnete Rastelemente 4a. Diese Rastelemente 4a sind geeignet, in einer Verriegelungsposition der Verriegelungsvorrichtung mit jeweils einer Rastöffnung 5a der Halterung 1a in Eingriff zu kommen. Der Aufbau der Rastelemente 4a gleicht im Wesentlichen dem Aufbau des in den Figuren 1 bis 13 dargestellten Rastelements 4. Das Gerät 2a umfasst einen Entriegelungshebel 21 a. Dieser Entriegelungshebel 21a ist mit den beiden Rastelementen 4a verbunden (nicht explizit in Figur 14 gezeigt). Der Entriegelungshebel 21a ist als Federelement ausgebildet, wodurch der Entriegelungshebel 21a selbst und die beiden Rastelemente 4a zu einem Boden des Gerätegehäuses 6a hin vorgespannt werden. Alternativ könnte die in Figur 14 dargestellte Verriegelungsvorrichtung auch ein separates Federelement zum Vorspannen des Entriegelungshebels 21a und der beiden Rastelemente 4a zu dem Boden des Gerätegehäuses 6a hin umfassen. Zum Entriegeln eines in der Halterung 1a verriegelten Geräts 2a muss der Entriegelungshebel 21a in Richtung der Betätigungsrichtung Ba betätigt werden. Dadurch fahren die Rastelemente 4a aus den Rastöffnungen 5a aus. Zum Herausziehen des Geräts 2a aus der Halterung 1a kann dann bei betätigtem Entriegelungshebel 21 a das Gerät 2a an der fest am Gerät 2a montierten Bedienlasche 8a aus der Halterung 1a herausgezogen werden. Somit sind zum Herausziehen des Geräts 2a aus der Halterung 1a zwei Hände notwendig, nämlich eine zum Entriegeln und eine zum Herausziehen. Dies hat den Vorteil, dass es nicht möglich ist, das Gerät 2a einhändig herauszuziehen, wodurch eine gewissenhafte und sichere Handhabung des Geräts in jedem Fall gewährleistet wird. Alternativ zu einer derart beabstandeten Anordnung von Entriegelungshebel 21 a und Bedienlasche 8a, welche zum Entnehmen des Geräts 2a aus der Halterung 1a die Nutzung beider Hände bedingt, könnten Entriegelungshebel 21a und Bedienlasche 8a auch so nah beieinander angeordnet sein, dass ein Herausziehen des Geräts 2a aus der Halterung 1a mit einer einzigen Hand ermöglicht wird. Auch könnte der Entriegelungshebel 21a selbst eine Bedienlasche zum Herausziehen des Geräts 2a aus der Halterung 1a umfassen, so dass eine separate Bedienlasche entfallen könnte. Diese beiden alternativen Möglichkeiten könnten insbesondere bei kleinen und/oder leichten Einschubgeräten von Vorteil sein.

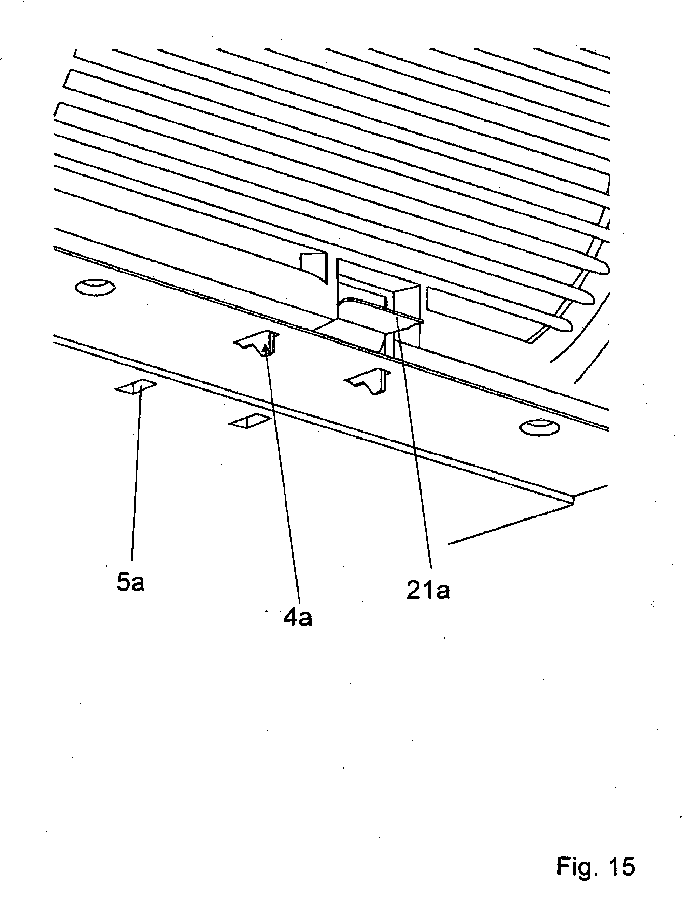

Figur 15 zeigt eine ausschnittsweise vergrösserte Darstellung der Verriegelungsvorrichtung aus Figur 14.

Die Erfindung ist nicht auf die hier gezeigten Ausführungsbeispiele beschränkt, vielmehr wird der Schutzbereich durch die Patentansprüche bestimmt.

## Patentansprüche

1. Vorrichtung zum Verriegeln eines Geräts (2) in einer Halterung (1), mit einem ersten Verriegelungselement (3), das ein erstes Rastelement (4) aufweist und von dem Gerät (2) umfasst ist, und einem zweiten Verriegelungselement (5), das ein zweites Rastelement (5) aufweist und von der Halterung (1) umfasst ist, wobei
- wenigstens eines der Verriegelungselemente (3, 5) beweglich gelagert und zum Verriegeln der beiden Rastelemente (4, 5) mit einer Kraft beaufschlagbar ist,
- die Verriegelungsvorrichtung einen ersten Anschlag (18) umfasst zur Begrenzung einer maximalen Auslenkung des beweglichen Verriegelungselementes (3) in Richtung der Kraft,
**dadurch gekennzeichnet, dass**
die Verriegelungsvorrichtung einen zweiten Anschlag (19) umfasst, der eine maximale Überlappung der beiden Verriegelungselemente (3, 5) im verriegelten Zustand definiert und dass
die beiden Anschläge (18, 19) derart angeordnet sind, dass das bewegliche Verriegelungselement (3) beim Verriegeln der beiden Verriegelungselemente (3, 5) an dem zweiten Anschlag (19) anschlägt, bevor es an dem ersten Anschlag (18) anschlägt.

2. Verriegelungsvorrichtung nach Anspruch 1, wobei sie ein Federelement (15) zur Beaufschlagung des beweglichen Rastelements (4) mit der Kraft umfasst.

3. Verriegelungsvorrichtung nach einem der Ansprüche 1 - 2, wobei das Federelement (15) einerseits an dem beweglichen Verriegelungselement (3) und andererseits an dem Gerät (2) bzw. einem Gehäuse des Geräts (6) oder der Halterung (1) abgestützt ist.

4. Verriegelungsvorrichtung nach einem der Ansprüche 1 - 3, wobei das erste Verriegelungselement (3) drehbar an dem Gehäuse des Gerätes (6) gelagert ist und das Federelement (15) eine Feder umfasst, welche an dem ersten Verriegelungselement (3) befestigt und an dem Gehäuse des Gerätes (6) abgestützt ist.

5. Verriegelungsvorrichtung nach einem der vorhergehenden Ansprüche, wobei das erste Rastelement (4) eine Rastnase (10) zum Eingreifen in eine Ausnehmung (5) der Halterung (1) umfasst.

6. Verriegelungsvorrichtung nach Anspruch 5, **dadurch gekennzeichnet, dass** das erste Rastelement (4) eine Anschlagskante (11) zum Anschlagen an dem zweiten Anschlag (19) umfasst.

7. Verriegelungsvorrichtung nach einem der vorhergehenden Ansprüche, **dadurch gekennzeichnet, dass** das erste Rastelement (4) eine erste Einfahrschräge (12) zum Erleichtern eines Einfahrens des Geräts (2) in die Halterung (1) umfasst.

8. Verriegelungsvorrichtung nach Anspruch 7, **dadurch gekennzeichnet, dass** die erste Einfahrschräge (12) zwischen der Rastnase (10) und der Anschlagskante (11) angeordnet ist.

9. Verriegelungsvorrichtung nach einem der vorhergehenden Ansprüche, **dadurch gekennzeichnet, dass** das erste Rastelement (4) eine zweite Einfahrschräge (13) zum Erleichtern eines Einfahrens des Geräts (2) in die Halterung (1) umfasst.

10. Verriegelungsvorrichtung nach Anspruch 9, **dadurch gekennzeichnet, dass** die zweite Einfahrschräge (13) von der Rastnase (10) aus gesehen hinter der ersten Einfahrschräge (12) und/oder der Anschlagskante (11) angeordnet ist.

11. Verriegelungsvorrichtung nach einem der vorhergehenden Ansprüche, **dadurch gekennzeichnet, dass** der erste Anschlag (18) durch das Gehäuse des Geräts (6) gebildet ist und/oder der zweite Anschlag (19) durch die Halterung (1) gebildet ist.

12. Verriegelungsvorrichtung nach einem der Ansprüche 5 bis 11, **dadurch gekennzeichnet, dass** das zweite Verriegelungselement (5) durch die Ausnehmung (5) der Halterung (1) gebildet ist.

13. Anordnung eines Geräts (2) in eine Halterung (1) zur Aufnahme des Geräts (2), umfassend eine Verriegelungsvorrichtung gemäss einem der vorhergehenden Ansprüche.

## Claims

1. Device for locking a unit (2) in a holder (1), having a first locking element (3), which has a first latching element (4) and is contained by the unit (2), and having a second locking element (5), which has a second latching element (5) and is comprised by the holder (1), wherein
- at least one of the locking elements (3, 5) is mounted in a movable manner and may be subjected to a force for the purpose of locking the two latching elements (4, 5),
- the locking device comprises a first stop (18), for limiting maximum deflection of the movable locking element (3) in the direction of the force,
**characterized in that**
the locking device comprises a second stop (19) for limiting overlapping of the two latching elements (3, 5) in the locked state, and **in that** the two stops (18, 19) are arranged such that, when the two locking elements (3, 5) are being locked, the movable locking element (3) strikes against the second stop (19) before it strikes against the first stop (18).

2. Locking device according to Claim 1, wherein it comprises a spring element (15) for subjecting the movable latching element (4) to the force.

3. Locking device according to one of Claims 1 - 2, wherein the spring element (15) is supported, on the one hand, on the movable locking element (3) and, on the other hand, on the unit (2) or a housing of the unit (6) or on the holder (1).

4. Locking device according to one of Claims 1 - 3, wherein the first locking element (3) is mounted in a rotatable manner on the housing of the unit (6) and the spring element (15) comprises a spring which is fastened on the first locking element (3) and is supported on the housing of the unit (6).

5. Locking device according to one of the preceding claims, wherein the first latching element (4) comprises a latching nose (10) for engaging in an aperture (5) of the holder (1).

6. Locking device according to Claim 5, **characterized in that** the first latching element (4) comprises a stop edge (11) for striking against the second stop (19).

7. Locking device according to one of the preceding claims, **characterized in that** the first latching element (4) comprises a first insertion slope (12) for facilitating insertion of the unit (2) into the holder (1).

8. Locking device according to Claim 7, **characterized in that** the first insertion slope (12) is arranged between the latching nose (10) and the stop edge (11).

9. Locking device according to one of the preceding claims, **characterized in that** the first latching element (4) comprises a second insertion slope (13) for facilitating insertion of the unit (2) into the holder (1).

10. Locking device according to Claim 9, **characterized in that** the second insertion slope (13) is arranged behind the first insertion slope (12) and/or the stop edge (11), as seen from the latching nose (10).

11. Locking device according to one of the preceding claims, **characterized in that** the first stop (18) is formed by the housing of the unit (6) and/or the second stop (19) is formed by the holder (1).

12. Locking device according to one of Claims 5 to 11, **characterized in that** the second locking element (5) is formed by the aperture (5) of the holder (1).

13. Arrangement of a unit (2) within a holder (1) for receiving the unit (2), comprising a locking device according to one of the preceding claims.

## Revendications

1. Dispositif pour verrouiller un appareil (2) dans un support (1), comprenant un premier élément de verrouillage (3) qui présente un premier élément d'encliquetage (4) et qui est entouré par l'appareil (2), et un deuxième élément de verrouillage (5), qui présente un deuxième élément d'encliquetage (5) et qui est entouré par le support (1),
- au moins l'un des éléments de verrouillage (3, 5) étant supporté de manière mobile et pouvant être sollicité par une force pour verrouiller les deux éléments d'encliquetage (4, 5),
- le dispositif de verrouillage comprenant une première butée (18) pour limiter une déviation maximale de l'élément de verrouillage mobile (3) dans la direction de la force,
**caractérisé en ce que**
- le dispositif de verrouillage comprend une deuxième butée (19) qui définit un chevauchement maximum des deux éléments de verrouillage (3, 5) dans l'état verrouillé, et **en ce que**
les deux butées (18, 19) sont disposées de telle sorte que l'élément de verrouillage mobile (3), lors du verrouillage des deux éléments de verrouillage (3, 5), bute contre la deuxième butée (19) avant de buter contre la première butée (18).

2. Dispositif de verrouillage selon la revendication 1, comprenant un élément de ressort (15) pour solliciter l'élément d'encliquetage mobile (4) avec la force.

3. Dispositif de verrouillage selon l'une quelconque des revendications 1 à 2, dans lequel l'élément de ressort (15) est supporté d'une part sur l'élément de verrouillage mobile (3) et d'autre part sur l'appareil (2) ou sur un boîtier de l'appareil (6) ou du support (1).

4. Dispositif de verrouillage selon l'une quelconque des revendications 1 à 3, dans lequel le premier élément de verrouillage (3) est supporté de manière rotative sur le boîtier de l'appareil (6) et l'élément de ressort (15) comprend un ressort qui est fixé sur le premier élément de verrouillage (3) et qui est supporté sur le boîtier de l'appareil (6).

5. Dispositif de verrouillage selon l'une quelconque des revendications précédentes, dans lequel le premier élément d'encliquetage (4) comprend un ergot d'encliquetage (10) destiné à s'engager dans un évidement (5) du support (1).

6. Dispositif de verrouillage selon la revendication 5, **caractérisé en ce que** le premier élément d'encliquetage (4) comprend une arête de butée (11) pour buter contre la deuxième butée (19).

7. Dispositif de verrouillage selon l'une quelconque des revendications précédentes, **caractérisé en ce que** le premier élément d'encliquetage (4) comprend un premier biseau d'introduction (12) pour faciliter une introduction de l'appareil (2) dans le support (1).

8. Dispositif de verrouillage selon la revendication 7, **caractérisé en ce que** le premier biseau d'introduction (12) est disposé entre l'ergot d'encliquetage (10) et l'arête de butée (11).

9. Dispositif de verrouillage selon l'une quelconque des revendications précédentes, **caractérisé en ce que** le premier élément d'encliquetage (4) comprend un deuxième biseau d'introduction (13) pour faciliter une introduction de l'appareil (2) dans le support (1).

10. Dispositif de verrouillage selon la revendication 9, **caractérisé en ce que** le deuxième biseau d'introduction (13), vu depuis l'ergot d'encliquetage (10), est disposé derrière le premier biseau d'introduction (12) et/ou l'arête de butée (11).

11. Dispositif de verrouillage selon l'une quelconque des revendications précédentes, **caractérisé en ce que** la première butée (18) est formée par le boîtier de l'appareil (6) et/ou la deuxième butée (19) est formée par le support (1).

12. Dispositif de verrouillage selon l'une quelconque des revendications 5 à 11, **caractérisé en ce que** le deuxième élément de verrouillage (5) est formé par l'évidement (5) du support (1).

13. Agencement d'un appareil (2) dans un support (1) pour recevoir l'appareil (2), comprenant un dispositif de verrouillage selon l'une quelconque des revendications précédentes.
